Europäisches Patentamt

European Patent Office

Office européen des brevets

(19)

(11) EP 0 750 808 B1

(12) **EUROPÄISCHE PATENTSCHRIFT**

(45) Veröffentlichungstag und Bekanntmachung des Hinweises auf die Patenterteilung:
**14.01.1998 Patentblatt 1998/03**

(21) Anmeldenummer: **95911288.9**

(22) Anmeldetag: **03.03.1995**

(51) Int Cl.6: **H03K 17/08**, H03K 17/10, H03K 17/732, H02M 1/088

(86) Internationale Anmeldenummer:
**PCT/EP95/00789**

(87) Internationale Veröffentlichungsnummer:
**WO 95/25383 (21.09.1995 Gazette 1995/40)**

(54) **VERFAHREN UND VORRICHTUNG ZUR VERGLEICHMÄSSIGUNG DER SPANNUNGSAUFTEILUNG SERIENGESCHALTETER, GATEGESTEUERTER HALBLEITER**

PROCESS AND DEVICE FOR EQUALISING THE VOLTAGE DISTRIBUTION TO GATE-CONTROLLED, SERIES-CONNECTED SEMICONDUCTORS

PROCEDE ET DISPOSITIF D'EGALISATION DE LA REPARTITION DE LA TENSION ENTRE DES SEMI-CONDUCTEURS BLOCABLES ET MONTES EN SERIE

(84) Benannte Vertragsstaaten:
**AT BE CH DE FR GB IT LI SE**

(30) Priorität: **15.03.1994 EP 94104203**

(43) Veröffentlichungstag der Anmeldung:
**02.01.1997 Patentblatt 1997/01**

(73) Patentinhaber: **SIEMENS AKTIENGESELLSCHAFT 80333 München (DE)**

(72) Erfinder: **BAKRAN, Mark-Matthias D-64668 Rimbach (DE)**

(56) Entgegenhaltungen:
**EP-A- 0 288 422**

- **PATENT ABSTRACTS OF JAPAN vol. 17, no. 115 (E-1330) 10. März 1993 & JP,A,04 295 269 (TOSHIBA CORP) 20. Oktober 1992**
- **PATENT ABSTRACTS OF JAPAN vol. 016, no. 280 (E-1221) 23. Juni 1992 & JP,A,04 070 209 (HITACHI LTD) 5. März 1992**
- **PATENT ABSTRACTS OF JAPAN vol. 11, no. 390 (E-567) (2837) 19. Dezember 1987 & JP,A,62 154 815 (TOSHIBA CORP) 9. Juli 1987**
- **RESEARCH DISCLOSURE, Nr.319, November 1990, EMSWORTH, GB Seiten 893 - 894 'Turn-off control system for gate-turn-off thyristors'**

**Beschreibung**

Die Erfindung bezieht sich auf ein Verfahren und eine Vorrichtung zur Vergleichmäßigung der Spannungsaufteilung an einer Reihenschaltung unterschiedlich lange Abschaltzeiten aufweisender, gategesteuerter Halbleiter.

Unter gategesteuerten Halbleitern sollen hier sämtliche Halbleiter verstanden werden, die über ihren Steueranschluß (Gate) sowohl ein- als auch ausgeschaltet werden können.

Zur Erhöhung der Leistung von Stromrichtern ist die Erhöhung der Arbeitsspannung ein entscheidender Beitrag; die Reihenschaltung von Leistungshalbleitern stellt dabei eine Möglichkeit dar. Insbesondere Gate-Turn-Off-(GTO)Thyristoren sind dabei als Halbleiter interessant, da sie die höchste Sperrspannungsfestigkeit abschaltbarer Halbleiterventile aufweisen.

Das Hauptproblem bei der Serienschaltung liegt in dem nicht identischen Abschaltverhalten der Halbleiterventile, wodurch diese ungleichmäßig mit Sperrspannung belastet werden. Das unterschiedliche Abschaltverhalten, das sich vor allem durch verschiedene Abschaltzeiten bemerkbar macht, wird sowohl durch die Exemplarstreuung der Halbleiter als auch durch äußere Parameter, wie Abschaltstrom und Temperatur, verursacht. Werden keine anderen Maßnahmen getroffen, bedingt dies eine Überdimensionierung der Halbleiterventile sowie ihrer Beschaltung, womit derartige Schaltungen unwirtschaftlich werden und in der Anzahl der seriengeschalteten Halbleiterventile begrenzt werden.

Der Einschaltvorgang von seriengeschalteten Halbleiterventilen ist durch die Vorgaben der Stromrichterschaltung, in der immer eine Begrenzung des Stromanstiegs vorgesehen ist, durch die Sperrspannungsfestigkeit der Halbleiterventile zu dem Einschaltaugenblick und auch durch die nur geringen Unterschiede im Einschaltverhalten der Leistungshalbleiter relativ unkritisch. Die statische Sperrspannungsbelastung ist mit passiven Mitteln beherrschbar. Einschaltverhalten und statisches Sperren werden deshalb hier nicht weiter betrachtet.

Es muß also ein Weg gefunden werden, eine gleichmäßige dynamische Spannungsbelastung der Halbleiterventile während des Abschaltvorganges herbeizuführen. Als vorgegebene Randbedingungen müssen beachtet werden, daß der Stromrichter sofort bei voller Spannung betrieben werden muß und eine Selektion von Halbleiterventilen oder andere manuelle Maßnahmen vermieden werden müssen. Es muß außerdem beachtet werden, daß auf das Abschaltverhalten der Halbleiterventile, d.h. insbesondere auf die Unterschiede in der Abschaltzeit, außer der Halbleiterstreuung der Abschaltstrom und die Temperatur einwirken. Es muß also der Einfluß des sich sprunghaft ändernden Abschaltstromes genauso kompensiert werden wie der Einfluß der sich langsam ändernden Temperatur. Eine weitere Forderung an ein derartiges Verfahren zur Vergleichmäßigung der Spannungsverteilung bei seriengeschalteten Leistungshalbleitern ist die Sicherheit des Betriebes der Schaltung in allen (auch Fehler-) Zuständen.

Es sind verschiedene Methoden bekannt, abschaltbare Halbleiterventile in Serie zu schalten und dabei ein sicheres Abschalten zu gewährleisten. Die Lösungsansätze reichen dabei von rein passiven Methoden über Maßnahmen, die einen manuellen Einsatz erfordern, bis zu Verfahren, die auf der Grundlage einer Regelung arbeiten.

Unter rein passiven Methoden sind Maßnahmen zu verstehen wie eine Überdimensionierung der Beschaltungskapazitäten, eine Überdimensionierung der Sperrspannungen der Halbleiterventile, eine Selektion der Halbleiterventile nach gleichem Abschalten als auch eine Selektion der Ansteuerungen und Beschaltungen. Dies geschieht mit dem Ziel, möglichst eine gleichmäßige, dynamische Sperrspannungsverteilung zu erhalten.

Als manueller Eingriff in die Schaltung sind Methoden bekannt, die durch eine manuelle Justierung der Abschaltzeitpunkte, erreichbar durch Verzögerungen in den Ansteuerungen oder unterschiedliche Gate-Induktivitäten, eine gleichmäßige Sperrspannungsverteilung an den Halbleiterventilen zu erreichen suchen.

Diese Lösungsansätze sind augenscheinlich nicht in der Lage, die oben aufgeführten Forderungen an ein Verfahren zur Serienschaltung von Halbleiterventilen zu erfüllen. Vor allem lassen sie die Serienschaltungen von Halbleiterventilen als unwirtschaftlich erscheinen.

Aus der EP 0 288 422 B1 ist ein Verfahren zur Vergleichmäßigung der Spannungsaufteilung beim Abschalten einer Reihenschaltung gesteuerter Halbleiter bekannt, das auf einer Regelung der Sperrspannungen der Halbleiterventile basiert, indem die Abschaltpunkte der einzelnen Halbleiterventile ansteuerseitig entsprechend verzögert werden. Bei diesem Verfahren werden die tatsächlichen Amplituden der Anodenspannungen der seriengeschalteten Halbleiterventile gemessen und mit der Amplitude der Gesamtspannung der seriengeschalteten Halbleiterventile derart verglichen, daß eine Korrekturgröße gebildet wird, die die Abschaltverzögerungen für die einzelnen Halbleiterventile bestimmt. Dadurch werden die Spannungsdifferenzen zwischen den Halbleitern im Idealfall zu Null kompensiert. Das Abschalten der Leistungshalbleiter erfolgt bei anfangs nur geringem Strom bis schließlich vollem Betriebsstrom, wobei die Differenz zwischen den Abschaltströmen zweier aufeinanderfolgender Abschaltvorgänge die festgelegten Verzögerungszeiten für die einzelnen Halbleiterventile korrigiert. Zur Erzeugung der Verzögerungszeiten für die einzelnen Halbleiterventile sind Differenzbildner vorgesehen. Damit soll ein der gemessenen Spannungsdifferenz zwischen tatsächlicher und idealer Spannungsverteilung proportionales Signal erzeugt werden, das gleichzeitig den Wert der Abschaltverzögerung für das jeweilige Halbleiterventil darstellt. Der hiermit beschriebene Regler weist somit ein rein proportionales Verhalten auf. Unterschiedliche Abschaltströme zwischen aufeinanderfolgenden Schaltvorgängen sollen über einen Stromdifferenzbildner eine zusätzliche Verzögerung der Abschaltsignale bewirken, um den Einfluß eines sich ändernden Stromes zu kompensieren. Dieses Regelsystem ist interessant bei Halbleiterventilen mit nur geringer Abhängigkeit ihrer Abschaltzeit vom Abschaltstrom und insgesamt recht robustem Verhalten, so z.B. Leistungstransistoren und Insulated-Gate-Bipolar-Transistors (IGBT). Bei solchen Halbleiterventilen scheint jedoch auch eine noch einfachere reine nachführende Regelung verwirklichbar, die entweder bei der Überschreitung einer von außen vorgegebenen oder einer fest eingestellten Spannung des betroffenen Halbleiterventils im Abschalten verzögert.

Der Erfindung liegt nun die Aufgabe zugrunde, ein Verfahren und eine Vorrichtung zur Vergleichmäßigung der Spannungsaufteilung bei seriengeschalteten, gategesteuerten Halbleitern anzugeben, mit dem zu jedem Abschaltaugenblick die richtigen Verzögerungszeiten für die seriengeschalteten, gategesteuerten Halbleiterventile ausreichend genau bekannt sind, um ein sicheres Abschalten zu gewährleisten.

Diese Aufgabe wird erfindungsgemäß gelöst mit den Verfahrensmerkmalen a) bis g) des Anspruchs 1 und den kennzeichnenden Merkmalen des Anspruchs 4.

Das erfindungsgemäße Verfahren basiert auf der Aufteilung eines zulässigen Abschaltstrombereichs der seriengeschalteten, gategesteuerten Halbleiter in mehrere Bereiche, wobei für jeden Bereich für jeden der seriengeschalteten Halbleiterventile vorbestimmte Verzögerungszeiten zur Verfügung stehen. Dadurch stehen schon während des Ein-Zustands für einen momentanen Strom Verzögerungszeiten zur Verfügung, so daß zu jedem Abschaltaugenblick ausreichend genaue Verzögerungszeiten für die Halbleiterventile zur Verfügung stehen. Da außerdem die vorbestimmten Verzögerungszeiten immer nach erfolgtem Abschalten aktualisiert werden, passen sich die Verzögerungszeiten von Schalthandlung zu Schalthandlung immer an den Betrieb des Stromrichtergerätes an, dessen Stromrichterventile jeweils aus seriengeschalteten, gategesteuerten Halbleitern bestehen. Bei diesem Verfahren werden auch sich verändernde Einflußgrößen, wie Abschaltstrom und Temperatur, berücksichtigt. Somit erhält man ein Verfahren zur Vergleichmäßigung der Spannungsaufteilung von seriengeschalteten, gategesteuerten Halbleitern, das sich automatisch immer auf den aktuellsten Betriebszustand einstellt, wodurch man ein lernfähiges Verfahren erhält.

Bei einem vorteilhaften Verfahren werden die vorbestimmten Ausschaltverzögerungszeiten mittels einer Lernphase selbsttätig ermittelt. Die Lernphase des Systems unterscheidet sich von Verfahren gemäß Anspruch 1 dadurch, daß hierbei eine Vorgabe bzw. Begrenzung des Abschaltstromes vom Regelungssystem gegeben wird. Im einfachsten Fall läuft die Lernphase dabei so ab, daß der Stromrichter zuerst mehrmals im kleinsten Strombereich abgeschaltet wird, so daß durch eine Einstellung der Verzögerungszeiten für die einzelnen Ventile die Spannungsungleichverteilung annähernd zu Null korrigiert wird. Ist dies im ersten Strombereich geschehen, so wird diese Verzögerungszeit im nächsten Strombereich als Anfangswert übergeben. Nun erfolgt für diesen höheren Strom der gleiche Regelvorgang, bis auch hierfür die Spannungsungleichverteilung kompensiert ist. Bei richtiger Dimensionierung dauert ein Einregelvorgang nicht mehr als zwei Schaltvorgänge. Dieser beschriebene Vorgang wird bis zum höchsten Strombereich wiederholt. Daß dabei die Spannungsfehlverteilung immer in Grenzen gehalten werden kann, basiert auf dem stetigen Zusammenhang zwischen Abschaltstrom und Abschaltzeit bei Halbleiterventilen. Die maximale Spannungsfehlverteilung während der Lernphase kann durch die Festlegung der Strombereiche bestimmt werden.

Bei einer vorteilhaften Vorrichtung zur Durchführung des erfindungsgemäßen Verfahrens wird zur Realisierung des Verfahrens ein Mikroprozessor vorgesehen, dem ein Strommeßwert, Spannungsmeßwerte der erfaßten Sperrspannungsverteilung und Ein- und Ausschaltsignale von einem Pulsmodulator zugeführt sind. Diese softwaremäßige Lösung bietet sich an, wenn der Pulsmodulator bereits einen Mikroprozessor verwendet. Dann ist es sogar vorteilhafter, wenn der Pulsmodulator und die Vorrichtung zur Durchführung des erfindungsgemäßen Verfahrens eine Baueinheit bilden.

Die Vorrichtung zur Durchführung des erfindungsgemäßen Verfahrens kann auch mit Hilfe diskreter Regler aufgebaut werden. Dabei wird für jeden Strombereich und für jeden seriengeschalteten, gategesteuerten Halbleiter ein diskreter I-Regler vorgesehen. Dieser Reglertyp gewährleistet sowohl eine Kompensation sich langsam ändernder Parameter (z.B. Temperatur) wie auch die Fähigkeit, sich die richtigen Verzögerungszeiten für die einzelnen Halbleiterventile zu merken. Bei jedem Abschalten der Ventile stehen Verzögerungszeiten am Ausgang des Reglers zur Verfügung, die aus einer Korrektur der Zeiten vom vorherigen Schaltvorgang bestehen, wobei der Korrekturwert einen zu der beim letzten Abschalten vorhandenen Spannungsfehlverteilung proportionalen Betrag darstellt.

Dadurch, daß jedem Bereich des Stromes ein eigener Regler zugeteilt ist, ist gewährleistet, daß bei jedem Abschaltvorgang Verzögerungszeiten zur Verfügung stehen, die dem jeweiligen Abschaltstrom entsprechen. Dieses Konzept, das auch bei der softwaremäßigen Lösung verwirklicht wird, erlaubt einen beliebigen, auch nicht linearen Zusammenhang zwischen den Verzögerungszeiten und dem Abschaltstrom. Außerdem gewährleistet es, daß beim Abschalten sofort die richtigen Verzögerungszeiten zur Verfügung stehen.

Die Erfassung des Abschaltstromes geschieht am günstigsten durch eine Messung des Ausgangsstromes des Stromrichters, da dieser bei entsprechender Richtung des Stromes identisch mit dem Ventilstrom ist. Der Vorteil dieses Verfahrens liegt darin, daß der Laststrom einfach meßtechnisch zugänglich ist bzw. schon meist als Meßwert potentialfrei vorliegt.

Die Messung der Spannungsfehlverteilung kann zum einen durch eine Messung der Anodenspannung über einem Halbleiterventil geschehen, welche dann mit dem Quotienten aus der gesamten Spannung über den Ventilen und der Anzahl der Halbleiter verglichen wird. Eine zweite Möglichkeit der Spannungsmessung besteht darin, nur die Spannungsdifferenz zwischen den einzelnen Kathodenpotentialen und einem parallel angebrachten Spannungsteilernetzwerk zu messen. Diese kleinen Spannungsdifferenzen werden miteinander verknüpft und von der Vorrichtung zu Null kompensiert. Gemeinsames Merkmal der Methoden ist, daß immer eine Erfassung der statischen Sperrspannungen erfolgt, also keine aufwendigen Meßwertaufnehmer für dynamische Vorgänge angewendet werden müssen.

Zur weiteren Erläuterung der Erfindung wird auf die Zeichnung bezug genommen, in der eine Vorrichtung zur Durchführung des erfindungsgemäßen Verfahrens zur Vergleichmäßigung der Spannungsaufteilung seriengeschalteter, gategesteuerter Halbleiterventile schematisch veranschaulicht ist.

Figur 1    zeigt ein Prinzipschaltbild einer vorteilhaften Ausführungsform einer erfindungsgemäßen Vorrichtung für die Ansteuerzeiten von seriengeschalteten, gategesteuerten Halbleitern, die

Figur 2    zeigt ein Ablaufdiagramm für eine lernfähige Regelung der Abschaltverzögerungszeiten für seriengeschaltete, gategesteuerte Halbleiter, in der

Figur 3    ist ein Prinzipschaltbild für eine einfache Spannungserfassung dargestellt und in der

Figur 4    sind typische Zeitverläufe von Steuersignal, Steuerstrom sowie Anodenstrom und Anodenspannung an zwei seriengeschalteten, gategesteuerten Halbleitern mit einem Abschaltzeitunterschied ohne Kompensation jeweils in Diagrammen über der Zeit t dargestellt, wobei in der

Figur 5    diese Signalverläufe mit Kompensation der ansteuerseitigen Abschaltzeiten jeweils in Diagrammen über der Zeit t dargestellt sind.

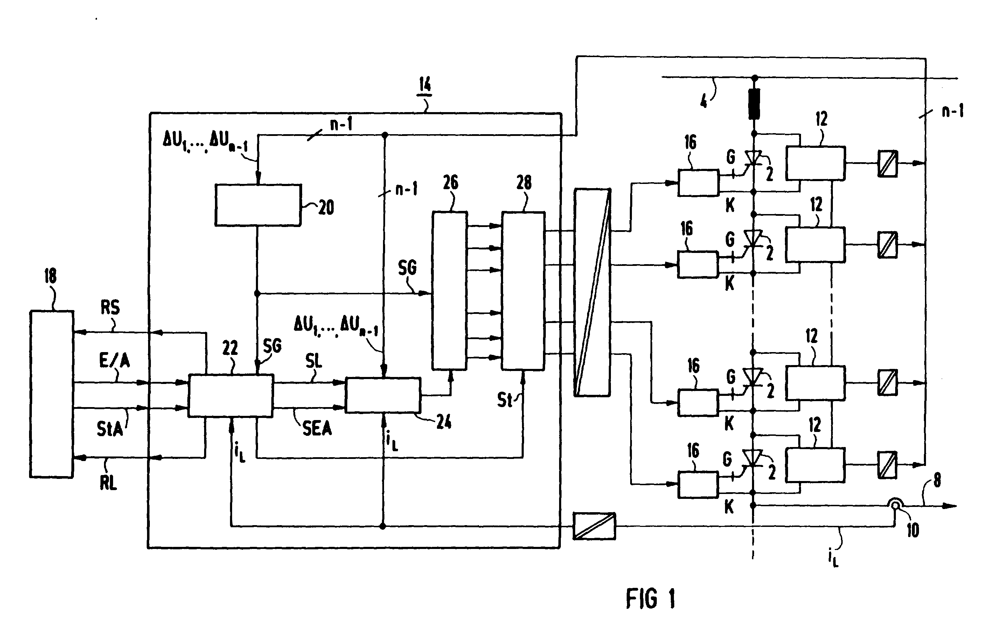

Die Figur 1 zeigt ein Prinzipschaltbild eines lernfähigen Regelsystems zur Vergleichmäßigung der Spannungsaufteilung an einer Reihenschaltung unterschiedlich langer Abschaltzeiten aufweisender, gategesteuerter Halbleiter 2. Als gategesteuerte Halbleiter 2 sind hier abschaltbare Thyristoren (GTO-Thyristoren) vorgesehen. Diese GTO-Thyristoren 2 bilden eine Hälfte eines Brückenzweiges einer nicht näher dargestellten Stromrichterschaltung. Diese Stromrichterschaltung, beispielsweise ein 6-pulsiger Wechselrichter, wird aus einer Gleichspannungsquelle gespeist, von der nur eine positive Zwischenkreisschiene 4 dargestellt ist. Der dargestellte Teil des Brückenzweiges weist neben den n GTO-Thyristoren 2 auch noch eine Drossel 6 zur Strombegrenzung auf. Am Mittelpunkt des Brückenzweiges ist ein Lastanschluß 8 angeschlossen, der einen Stromwandler 10 zur Erfassung des Laststromes $i_L$ aufweist. Jedes Halbleiterventil 2 ist mit einer Einrichtung 12 versehen, die elektrisch parallel zum Ventil geschaltet ist.

Diese Einrichtung 12 enthält ein bekanntes Entlastungsnetzwerk, beispielsweise eine RCD-Beschaltung, allgemein auch snubber circuit genannt, einen Widerstand eines Spannungsteilernetzwerkes und eine Meßspannungseinrichtung, mit der jeweils ein Wert einer Spannungsfehlverteilung gemessen werden kann. Die bekannte RCD-Beschaltung besteht aus einer Reihenschaltung aus einem Beschaltungskondensator und einer Beschaltungsdiode, der ein ohmscher Widerstand elektrisch parallel geschaltet ist. Die Spannungaufteilung an der Reihenschaltung der n Halbleiterventile 2 wird im stationären Zustand durch die jedem Halbleiter 2 parallel geschalteten Widerstände gewährleistet. Dieser stationäre Zustand, dessen Spannungsverteilung sich nur langsam durch relativ hochohmige parallel geschaltete Widerstände einstellt, ist nur bei einem Dauer-Aus-Zustand der Ventile 2 von eigentlicher Bedeutung. Demgegenüber bleibt die direkt nach dem Abschaltvorgang vorhandene Spannungsfehlverteilung fast unverändert während einer normalen Pulsdauer bestehen, wodurch diese Fehlverteilung quasi stationär während der Ausphase zugänglich ist. Außerdem weist jede Einrichtung 12 auch noch eine Freilaufdiode für das zugehörige Halbleiterventil 2 auf. Das Ausgangssignal, nämlich der Wert $\Delta U_1$, $\Delta U_2$ ..., $\Delta U_{n-2}$, $\Delta U_{n-1}$ der Spannungsfehlverteilung, wird jeweils potentialgetrennt über eine der n-1 Leitungen zur Vorrichtung 14 geführt.

Die Ansteuerung der n Halbleiterventile 2 zum Einschalten und zum Abschalten erfolgt jeweils mittels einer bekannten Treiberschaltung 16, die jeweils an einem Steueranschluß G und einer Kathode K des betreffenden gategesteuerten Halbleiters 2 angeschlossen sind. Eingangsseitig sind die Treiberschaltungen 16 jeweils potentialgetrennt mit den Ausgängen der Vorrichtung 14 verbunden.

Für die Potentialtrennung bietet sich an, eine Spannungsfrequenzumsetzung mit Optokopplern und Lichtleitern oder eine Digitalisierung des Meßwertes auf Meßpotential mit optischer Übertragung des digitalen Signals. Zur vereinfachten Signalübertragung erscheint es dabei auch möglich, nur eine sehr grobe Messung der Spannungsfehlverteilung vorzusehen.

Die Vorrichtung 14 zur Vergleichmäßigung der Spannungsaufteilung an seriengeschalteten, gategesteuerten Halbleitern 2 ist eingangsseitig mit einem Pulsmodulator 18 des Stromrichtergerätes verknüpft, von der es ein Steuersignal E/A (Ein- bzw. Ausschaltsignal) und ein Startsignal StA erhält. Dieser Modulator 18 erhält von der Vorrichtung 14 jeweils ein Rückmeldesignal RS bzw. RL betreffend den Schaltzustand der Halbleiterventile 2 bzw. der Lernphase. Die Vorrichtung 14 besteht aus einer Unsymmetrie-Überwachung 20, einer Steuereinrichtung 22, einer Recheneinrichtung 24, einer Zwischenspeichereinrichtung 26 und einer Ausgabeeinrichtung 28. Die Steuereinrichtung 22 ist in der Vorrichtung 14 eingangsseitig angeordnet und empfängt vom Pulsmodulator 18 das Startsignal ST oder das Steuersignal E/A. Außerdem wird dieser Steuereinrichtung 22 noch ein Aus-Signal SG und ein Strommeßsignal des Laststromes $i_L$ zugeführt. Von der Steuereinrichtung 22 werden einerseits die Rückmeldesignale RS und RL für den Modulator 18 und andererseits Statussignale SL, SEA für die Recheneinrichtung 24 und ein Startsignal St für die Ausgabeeinrichtung 28 generiert. Der Recheneinrichtung 24 werden außerdem noch die Werte $\Delta U_1$, ..., $\Delta U_{n-1}$ der Spannungsfehlverteilung und ein Strommeßsignal des Laststromes $i_L$ zugeführt.

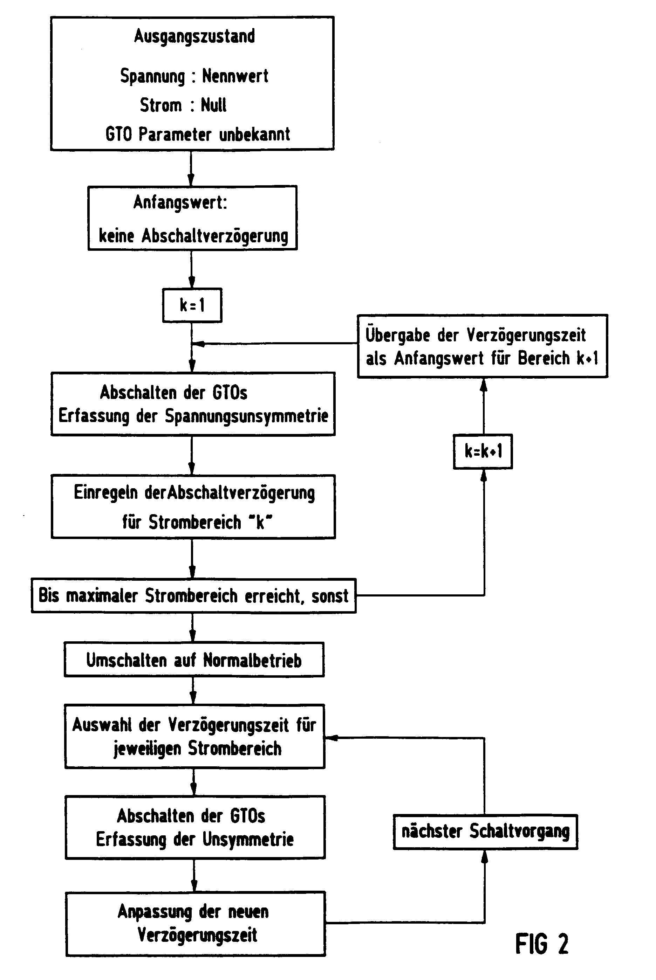

Das erfindungsgemäße Verfahren wird anhand dieses Prinzipschaltbildes und des Ablaufdiagrammes gemäß Figur 2 näher beschrieben, wobei zunächst das Verfahren nach Anspruch 1 und dann das Lernprogramm näher erläutert wird:

In der Recheneinrichtung 24 ist eine Tabelle mit Verzögerungszeiten für k Strombereiche und n Halbleiterventile 2 vorgesehen, wobei diese Verzögerungszeiten beispielsweise mittels des Lernprogramms, das ein Unterprogramm des erfindungsgemäßen Verfahrens ist, erstellt werden können. Während des Normalbetriebs erhält die Steuereinrichtung 22 der Vorrichtung 14 vom Pulsmodulator 18 ein Steuersignal E bzw. A. Darauf aktiviert die Steuereinrichtung 22 das Statussignal SEA, wodurch die Recheneinrichtung 24 in den Schaltmodus gesetzt wird. Abhängig von einem nicht näher dargestellten Taktsignal werden fortlaufend Meßwerte des Laststromes $i_L$ in die Recheneinrichtung 24 eingelesen, wobei zu diesem Strommeßbereich beim nächsten Takt aus der Tabelle n zugehörige Verzögerungszeiten ausgelesen werden, die beim nächsten Takt in der Zwischenspeichereinrichtung 26 abgelegt werden. Wechselt nun das Steuersignal des Modulators 18 von E nach A (Aus-Zustand), so generiert die Steuereinrichtung 22 das Startsignal St, womit die in der Zwischenspeichereinrichtung 26 abgelegten n Verzögerungszeiten in der Ausgabeeinrichtung 28 übernommen werden, so daß die n Halbleiterventile 2 jeweils mit ihrer individuellen Verzögerungszeit ausgeschaltet werden. Außerdem wechselt der Pegel des Statussignals SEA, so daß die zuletzt aufgerufenen Verzögerungszeiten gemerkt werden.

Nach erfolgtem Abschalten der n seriengeschalteten, gategesteuerten Halbleiter 2 werden die für den Abschaltstrombereich gemerkten Verzögerungszeiten aktualisiert. Dies geschieht, indem nach einem vorzugebenden Zeitraum in Abhängigkeit von Spannungswerten für jedes Ventil 2 ein Wert $\Delta U_1$, ..., $\Delta U_{n-1}$ der Spannungsfehlverteilung gebildet wird und der Unsymmetrie-Überwachung 20 und der Recheneinrichtung 24 zugeführt werden. Aus diesen Werten $\Delta U_1$, ..., $\Delta U_{n-1}$ der Spannungsfehlverteilungen ermittelt die Recheneinrichtung 24 für diesen Abschaltstrombereich neue Verzögerungszeiten, indem zu den gemerkten Verzögerungszeiten jeweils ein einer Verknüpfung aus den Werten $\Delta U_1$, ..., ..., $\Delta U_{n-1}$ der Spannungsfehlverteilung proportionaler Betrag addiert wird.

Die Werte $\Delta U_1$, ..., $\Delta U_{n-1}$ der Spannungsfehlverteilung können beispielsweise gemäß folgender Gleichung

$$U_{Unsym.Vi} = \Delta U_{n-1} + \Delta U_i - \Delta U_{i-1}$$

miteinander verknüpft werden, wobei n die Anzahl der seriengeschalteten Ventile 2 und i das 1., 2., ..., i-te Ventil 2 angibt.

Diese aktualisierten Verzögerungszeiten werden für diesen Abschaltstrombereich in der Tabelle hinterlegt, d.h., die aktuellen Verzögerungszeiten überschreiben die entsprechenden abgespeicherten Verzögerungszeiten für diesen Strombereich. Dadurch paßt sich die Vorrichtung 14 laufend an veränderbare Parameter an. Übersteigt ein Wert der Spannungsfehlverteilungen einen vorbestimmten Grenzwert, so wird die Vorrichtung 14 abgeschaltet und durch ein optisches Signal kenntlich gemacht. Durch die Abschaltung wird verhindert, daß beim nächsten Schaltvorgang infolge einer zu großen Spannungsfehlverteilung die seriengeschalteten, gategesteuerten Ventile 2 beschädigt bzw. zerstört werden.

Dies ist der typische Regelvorgang der Vorrichtung 14 im Normalbetrieb, womit deutlich wird, daß die Vorrichtung 14 ein integrierendes Verhalten aufweist, wodurch der Regelfehler, d.h. die Spannungsungleichverteilung, zu Null kompensiert werden kann. Die Taktfrequenz bzw. die Abtastzeit der Vorrichtung 14 entspricht der Schaltzeit der Ventile 2.

Anstelle der Tabelle in der Recheneinrichtung 24 kann auch für jeden Tabellenwert ein diskreter I-Regler verwendet werden, da dieser Reglertyp sowohl eine Kompensation sich langsam ändernder Parameter (z.B. Temperatur) wie auch die Fähigkeit, sich die richtigen Verzögerungszeiten für die einzelnen Halbleiterventile 2 zu "merken", gewährleistet.

Da beim ersten Einschalten des Stromrichters keine Verzögerungszeiten für die Halbleiterventile 2 bekannt sind, eine Spannungsüberlastung aber schon beim ersten Abschalten zur Zerstörung der Halbleiter 2 führen kann, werden mittels des erfindungsgemäßen Verfahrens in einer sogenannten Lernphase die Verzögerungszeiten ermittelt. Das Verfahren in der Lernphase unterscheidet sich von dem bereits dargestellten Verfahren dadurch, daß in der Lernphase eine Vorgabe bzw. eine Begrenzung des Abschaltstromes von einer Regelung gegeben wird.

Gemäß dem Ablaufdiagramm nach Figur 2 ist die Spannung gleich der Nennspannung, der Stromwert annähernd Null und die GTO-Parameter sind unbekannt. Da die Parameter der GTO-Ventile 2 nicht bekannt sind, können auch keine Abschaltverzögerungszeiten in der Vorrichtung 14 hinterlegt sein. Im kleinsten Strombereich k=1 werden die seriengeschalteten, gategesteuerten Halbleiter 2 abgeschaltet. Die ermittelten Werte $\Delta U_1$, ..., $\Delta U_{n-1}$ der Spannungsfehlverteilung werden mittels der Recheneinrichtung 24 in Verzögerungszeiten umgerechnet. Dieser Vorgang für den niedrigsten Strombereich k=1 kann mehrmals wiederholt werden, damit die Spannungsungleichverteilung annähernd zu Null korrigiert wird. Vorzugsweise dauert dieser Einregelvorgang nicht mehr als zwei Schaltvorgänge. Diese ermittelten n Verzögerungszeiten für den ersten Strombereich werden in der Tabelle der Recheneinrichtung 24 abgespeichert und als ausgewählte Verzögerungszeiten für den Strombereich k=2 gemerkt. Nach erfolgtem Abschalten werden diese gemerkten Verzögerungszeiten des Strombereichs k=2 mittels der ermittelten Werte $\Delta U_1$, ...., ..., $\Delta U_{n-1}$ der Spannungsfehlverteilung aktualisiert und in der Tabelle für den zweiten Strombereich abgespeichert. Gleichzeitig bilden diese Verzögerungszeiten wieder die Verzögerungszeiten für den nächsten Strombereich k=3. Diese Vorgänge werden solange wiederholt, bis der maximale Strombereich k=k erreicht ist.

In jedem Strombereich k können die Abschaltungen mehrmals durchgeführt werden, damit eine sehr hohe Genauigkeit bei der Ermittlung der Abschaltverzögerungszeiten erreicht wird. Bei dieser Lernphase der Vorrichtung 14 wird von einer nicht näher dargestellten Regelung der Strom vom Wert Null bis zum maximalen Abschaltstrom erhöht. Wenn für k Strombereiche jeweils n Abschaltverzögerungszeiten ermittelt worden sind, wird auf Normalbetrieb umgeschaltet.

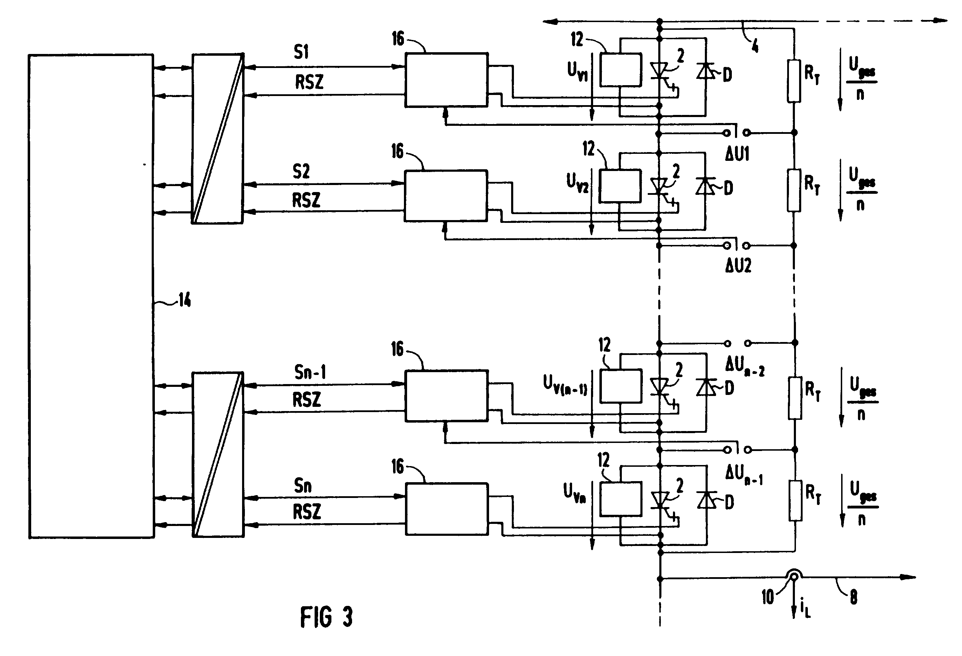

Die Messung der Spannungsfehlverteilung kann zum einen durch eine Messung der Anodenspannung $U_{V1}$, ..., $U_{Vn}$ über einem Halbleiterventil 2 geschehen, welche dann mit dem Quotienten $U_{ges/n}$ aus der gesamten Spannung $U_{ges}$ über den Ventilen 2 und der Anzahl n der Halbleiter 2 verglichen wird. Eine zweite Möglichkeit der Spannungsmessung besteht darin, nur die Spannungsdifferenz $\Delta U_1$, ...., ..., $\Delta U_{n-1}$ zwischen den einzelnen Kathodenpotentialen $U_{V1}$, ..., $U_{Vn}$ und einem parallel angebrachten Spannungsteilernetzwerk zu messen (Figur 3). Gemeinsames Merkmal dieser beiden Methoden ist, daß immer eine Erfassung der nach dem Abschalten vorhandenen, statischen Sperrspannung erfolgt, also keine aufwendigen Meßaufnehmer für dynamische Vorgänge angewendet werden müssen. In beiden Fällen wird eine potentialgetrennte Übertragung des Spannungsmeßwertes benötigt, wobei bei Erfassung der vollen Anodenspannung eine etwa um das Vierfache höhere Auflösung als bei der Erfassung der reinen Spannungsdifferenz benötigt wird. Die potentialgetrennte Übertragung geschieht sinnvollerweise durch Digitalisierung des Meßsignals und erscheint grundsätzlich im Rahmen der ohnehin vorhandenen Treiberrückmeldungen mit erträglichem Aufwand verwirklichbar.

In Figur 3 ist das Prinzipschaltbild für die Spannungserfassung bei Verwendung eines Widerstands-Teilernetzwerkes zur Messung der Spannungsfehlverteilung an den Halbleiterventilen 2 angegeben. Es wird deutlich, daß hierbei nur eine zusätzliche Rückmeldung RSZ des Treibers 16 erforderlich ist, nämlich, ob $\Delta U_{max}$ überschritten wurde -$\Delta U_{max}$ unterschritten wurde. Damit ist die A/D-Wandlung weggefallen und die Potentialtrennung auch denkbar einfach geworden.

Durch dieses erfindungsgemäße Verfahren werden langfristige Parameteränderungen, d.h. solche über mehrere Schaltvorgänge hinweg, wie z.B. die Temperaturänderung, durch eine reine nachführende Regelung ausgeglichen, wohingegen die sich schnell ändernde Einflußgröße Abschaltstrom als Steuergröße sofort und damit bei dem aktuellen Abschaltvorgang auf die Verzögerungszeiten wirkt. Durch diese Kombination zwischen Nachführen der Regelung und direkter Steuerung konnte eine sehr vorteilhafte Lösung des eingangs genannten Problems erreicht werden.

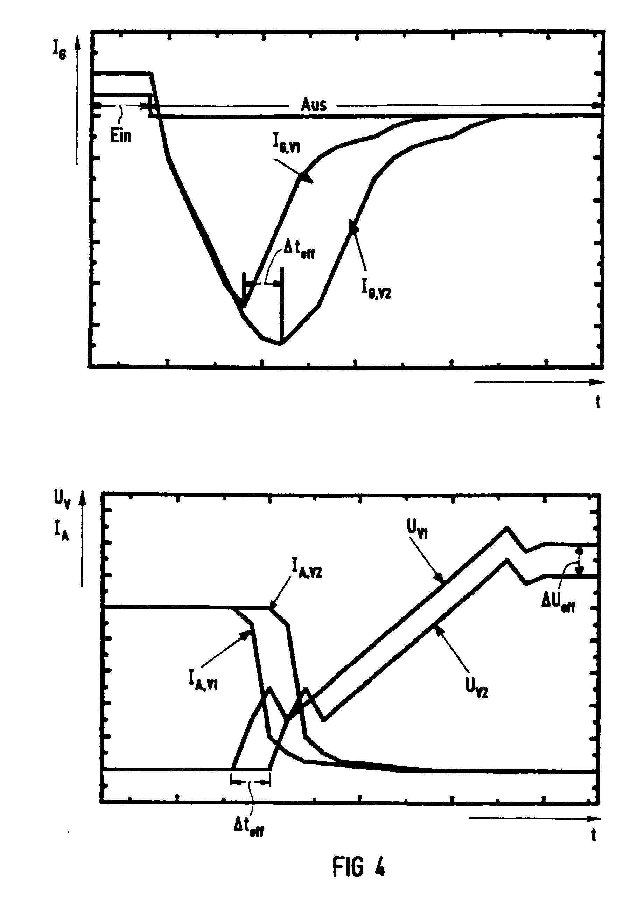

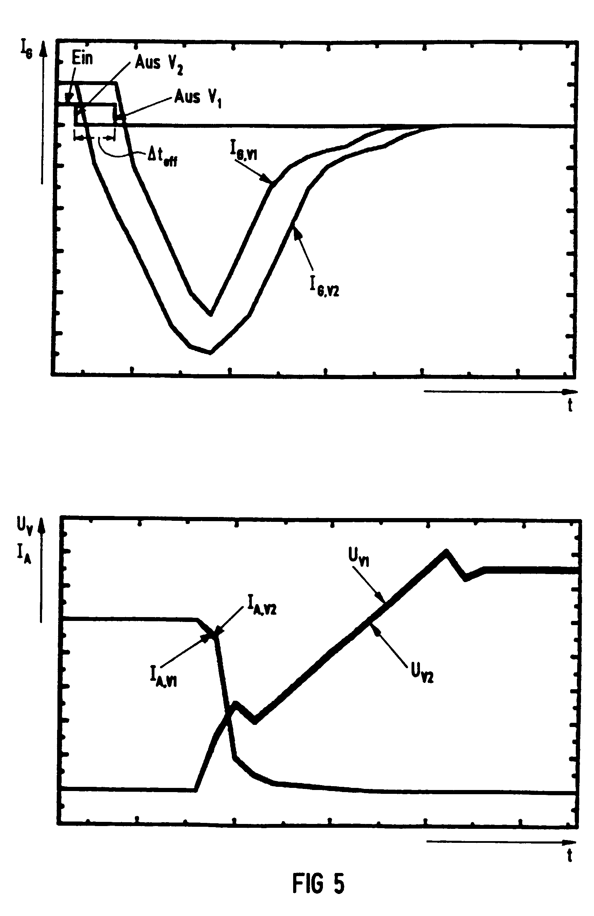

Zur Verdeutlichung der Wirkung des erfindungsgemäßen Verfahrens zur Vergleichmäßigung der Spannungsaufteilung von seriengeschalteten, gategesteuerten Halbleiterventilen 2 sind in den Figuren 4 und 5 jeweils Zeitverläufe für das Abschalten von zwei seriengeschalteten Halbleitern 2, die verschiedene Abschaltzeiten aufweisen, jeweils in Diagrammen über der Zeit t dargestellt. In den Diagrammen sind die typischen Zeitverläufe von Steuersignal S, Steuerstrom $I_{GV1}$, $I_{GV2}$ sowie Anodenstrom $I_{AV1}$, $I_{AV2}$ und Anodenspannung $U_{V1}$, $U_{V2}$ dargestellt. Der Abschaltzeitunterschied $\Delta t_{off}$ ist in der Figur ungleich Null, wogegen dieser Abschaltzeitunterschied $\Delta_{toff}$ in der Figur 5 mittels dem erfindungsgemäßen Verfahren zu Null korrigiert worden ist. Durch entsprechende Verzögerung des schnelleren Halbleiterventils ist der Spannungsverlauf an den Ventilen 2 vergleichmäßigt worden.

Ein weiterer Vorteil des erfindungsgemäßen Verfahrens ist die Fähigkeit des Systems, ohne aufwendige Eichungen automatisch starten zu können und dabei einen sicheren Betrieb des Stromrichters zu gewährleisten. Durch das Verfahren in der sogenannten Lernphase wird das Problem der nicht bekannten Verzögerungszeiten für die Halbleiterventile 2 bei der ersten Inbetriebnahme, nach Austauschen von Bauteilen oder nach längerem Stillstand gelöst.

**Patentansprüche**

1. Verfahren zur Vergleichmäßigung der Spannungsaufteilung an einer Reihenschaltung unterschiedlich lange Abschaltzeiten aufweisender, gategesteuerter Halbleiter (2), gekennzeichnet durch folgende Verfahrensschritte:

a) Während eines Ein-Zustandes der seriengeschalteten, gategesteuerten Halbleiter (2) wird ein durch diese Halbleiter (2) fließender Strom ($i_L$) gemessen,

b) in Abhängigkeit dieses gemessenen Stromwertes wird für die seriengeschalteten, gategesteuerten Halbleiter (2) jeweils eine vorbestimmte Ausschaltverzögerungszeit aufgerufen,

c) mit Eintreffen eines Abschaltsignales (A) werden die seriengeschalteten, gategesteuerten Halbleiter (2) mit den ermittelten Ausschaltverzögerungszeiten abgeschaltet,

d) nach erfolgter Abschaltung dieser Halbleiter (2) wird nach einem vorzugebenden Zeitraum die Sperrspannungsverteilung über diese Halbleiter (2) erfaßt,

e) in Abhängigkeit dieser erfaßten Sperrspannungsverteilung werden Werte einer Spannungsfehlverteilung ermittelt,

f) die aufgerufenen Ausschaltverzögerungszeiten werden aktualisiert, indem jeweils ein einer Verknüpfung aus den ermittelten Werten ($\Delta U_1 ..., \Delta U_{n-1}$) der Spannungsfehlverteilung proportionaler Betrag addiert wird und

g) diese aktualisierten Ausschaltverzögerungszeiten hinterlegt werden.

2. Verfahren nach Anspruch 1, wobei die vorbestimmten Ausschaltverzögerungszeiten bei Inbetriebnahme selbsttätig mittels einer Lernphase ermittelt und hinterlegt werden.

3. Verfahren nach Anspruch 2, wobei die Lernphase durch folgende Verfahrensschritte gekennzeichnet ist:

a) Der Meßbereich des durch die seriengeschalteten, gategesteuerten Halbleiter (2) fließenden Stromes ($i_L$) wird in k Strommeßbereiche unterteilt,

b) für jeden Strombereich werden die Verfahrensschritte a) bis g) nach Anspruch 1 durchgeführt, wobei jeweils zu hinterlegende aktualisierte Ausschaltverzögerungszeiten gleichzeitig als vorbestimmte Ausschaltverzögerungszeiten für den nachfolgenden Strommeßbereich dienen und

c) nachdem für alle k Strommeßbereich jeweils aktualisierte Ausschaltverzögerungszeiten ermittelt sind, wird auf Normalbetrieb umgeschaltet.

4. Vorrichtung (14) zur Durchführung des Verfahrens nach Anspruch 1 für eine Reihenschaltung unterschiedlich lange Abschaltzeiten aufweisende, gategesteuerter Halbleiter (2), an deren Steueranschlüssen (G, K) jeweils eine Treiberschaltung (16) angeschlossen ist, die mittels einer Potentialtrenneinrichtung mit einem Pulsmodulator (18) elektrisch leitend verbunden sind, **dadurch gekennzeichnet**, daß diese Vorrichtung (14) eine Steuereinrichtung (22), eine Recheneinrichtung (24), eine Zwischenspeichereinrichtung (26) und eine Ausgabeeinrichtung (28) aufweist und zwischen dem Pulsmodulator (18) und der Potentialtrenneinrichtung geschaltet ist, wobei die Steuereinrichtung (22) in Abhängigkeit der Signale (StA, E/A) des Pulsmodulators (18) die Recheneinrichtung (24) und die Ausgabeeinrichtung (28) steuert, wobei ein Meßwert des Laststromes ($i_L$) der Steuereinrichtung (22) und der Recheneinrichtung (24) zugeführt sind und wobei der Recheneinrichtung (24) noch Spannungsmeßwerte ($U_{V1}, ..., U_{Vn}; \Delta U_1, ..., \Delta U_{n-1}$) der an den Halbleitern (2) erfaßten Sperrspannungsverteilung zugeführt werden.

5. Vorrichtung (14) nach Anspruch 4, **dadurch gekennzeichnet**, daß die Vorrichtung (14) eine Unsymmetrie-Überwachung (20) enthält, der eingangsseitig Spannungsmeßwerte ($\Delta U_1, ..., \Delta U_{n-1}$) der an den Halbleitern (2) erfaßten Sperrspannungsverteilung zugeführt werden und die ausgangsseitig einerseits mit der Steuereinrichtung (22) und andererseits mit der Zwischenspeichereinrichtung (26) verknüpft ist.

6. Vorrichtung (14) nach Anspruch 4, **dadurch gekennzeichnet,** daß als Vorrichtung (14) ein Mikroprozessor vorgesehen ist.

7. Vorrichtung (14) nach Anspruch 4, **dadurch gekennzeichnet,** daß die Vorrichtung (14) und der Pulsmodulator (18) eine Baueinheit bilden.

**Claims**

1. Method for producing a uniform voltage distribution across a series circuit of gate-controlled semiconductors (2) exhibiting turn-off times of different length, characterized by the following method steps:

a) During an on state of the series-connected gate-controlled semiconductors (2), a current

($i_L$) flowing through the semiconductors (2) is measured,

b) in dependence on this measured current value, a predetermined turn-off delay time is in each case called up for the series-connected data-controlled semiconductors (2),

c) when a turn-off signal (A) arrives, the series-connected gate-controlled semiconductors (2) are turned off with the turn-off delay times determined,

d) after these semiconductors (2) have been turned off, the reverse-voltage distribution over the semiconductors (2) is detected after a period of time to be predetermined,

e) values of a voltage distribution error are determined in dependence on this detected reverse-voltage distribution,

f) the turn-off delay times called up are updated by an amount proportional to a combination of the values ($\Delta U_1$ ..., $\Delta U_{n-1}$) found for the voltage distribution error being added in each case, and

g) these updated turn-off delay times are stored.

2. Method according to Claim 1, the predetermined turn-off delay times being automatically determined and stored by means of a learning phase on start-up.

3. Method according to Claim 2, the learning phase being characterized by the following method steps:

a) the measuring range of the current ($i_L$) flowing through the series-connected gate-controlled semiconductors (2) is subdivided into k current measuring ranges,

b) for each current range, method steps a) to g) according to Claim 1 are carried out, updated turn-off delay times to be stored in each case being used at the same time as predetermined turn-off delay times for the subsequent current measuring range, and

c) after updated turn-off delay times have been determined in each case for all k current measuring ranges, the system switches to normal operation.

4. Device (14) for carrying out the method according to Claim 1 for a series circuit of gate-controlled semiconductors (2) which exhibit turn-off times of different lengths, the control terminals (G, K) of which are in each case connected to a driver circuit (16) which is electrically conductively connected to a pulse modulator (18) by means of a potential isolating device, characterized in that this device (14) exhibits a control device (21), an arithmetic device (24), a buffer storage device (26) and an output device (28) and is connected between the pulse modulator (18) output and the potential isolating device, the control device (22) controlling the arithmetic device (24) and the output device (28) in dependence on the signals (StA, E/A) of the pulse modulator (18), a measurement value of the load current ($i_L$) being supplied to the control device (22) and to the arithmetic device (24) and the arithmetic device (24) also being supplied with voltage measurement values ($U_{V1}$ ..., $U_{Vn}$; $\Delta U_1$, ..., $\Delta U_{n-1}$) of the reverse-voltage distribution detected at the semiconductors (2).

5. Device (14) according to Claim 4, characterized in that the device (14) contains an imbalance monitor (20) which is supplied with voltage measurement values ($\Delta U_1$ ..., $\Delta U_{n-1}$) of the reverse-voltage distribution detected at the semiconductors (2) at the input end and which is linked at the output end, at the one end, to the control device (22) and, on the other hand, to the buffer storage device (26).

6. Device (14) according to Claim 4, characterized in that a microprocessor is provided as device (14).

7. Device (14) according to Claim 4, characterized in that the device (14) and the pulse modulator (18) form one constructional unit.

**Revendications**

1. Procédé d'égalisation de la répartition de la tension sur un circuit-série de semi-conducteurs (2) à commande par grille, ayant des temps de mise hors circuit de durée différente, caractérisé par les étapes opératoires suivantes :

a) dans un état de connexion des semi-conducteurs (2) à commande par grille, branchés en série, on mesure un courant ($i_L$) passant par ces semi-conducteurs (2),

b) en fonction de cette valeur de courant mesuré, on appelle pour chacun des semi-conducteurs (2) à commande par grille, montés en série, une durée de retard de déconnexion prescrite,

c) à l'arrivée d'un signal (A) de mise hors circuit, on met hors circuit les semi-conducteurs (2) à commande par grille, montés en série, en ayant les durées de retard de déconnexion obtenues,

d) une fois la mise hors circuit de ces semi-conducteurs (2) effectuée, après un laps de temps à prescrire, on détermine la répartition de la tension de blocage sur ces semi-conducteurs (2),

e) en fonction de cette répartition de la tension de blocage déterminée, on obtient des valeurs de mauvaise répartition de la tension,

f) on met à jour les durées de retard de déconnexion appelées en additionnant une valeur proportionnelle à une combinaison des valeurs $(\Delta U_1, ..., \Delta U_{n-1})$ déterminées de la mauvaise répartition de la tension et

g) on met en mémoire ces durées de retard de déconnexion mises à jour.

2. Procédé suivant la revendication 1, les durées de retard de déconnexion prescrites étant, lors de la mise en fonctionnement, déterminées et mises en mémoire automatiquement au moyen d'une phase d'apprentissage.

3. Procédé suivant la revendication 2, la phase d'apprentissage étant caractérisée par les étapes opératoires suivantes :

a) on subdivise en k domaines de mesure du courant le domaine de mesure du courant ($i_L$) passant dans les semi-conducteurs (2) à commande par grille montés en série,
b) on effectue pour chaque domaine de courant les étapes a) à g) opératoires de la revendication 1, des durées de retard de déconnexion actualisées, mises en mémoire, servant en même temps de durées de retard de déconnexion prescrites pour la zone de mesure du courant suivante, et
c) après que l'on a obtenu pour chacun de tous les k domaines de mesure du courant des durées de retard de déconnexion mises à jour, on commute au fonctionnement normal.

4. Dispositif (14) de mise en oeuvre du procédé suivant la revendication 1 pour un circuit-série de semi-conducteurs (2) à commande par grille, qui ont des temps de mise hors circuit de durée différente et à chacune des bornes (G, K) de commande desquels est raccordé un circuit (16) d'attaque, qui, au moyen d'un dispositif séparateur de potentiel, est relié de manière conductrice de l'électricité à un modulateur (18) d'impulsion, caractérisé en ce que ce dispositif (14) comporte un dispositif (22) de commande, un dispositif (24) de calcul, un dispositif (26) de mise en mémoire intermédiaire et un dispositif (28) de sortie et est monté entre le modulateur (18) d'impulsion et le dispositif séparateur de potentiel, le dispositif (22) de commande commandant le dispositif (24) de calcul et le dispositif (28) de sortie en fonction des signaux (StA, E/A) du modulateur (18) d'impulsion, une valeur de mesure du courant ($i_L$) de charge étant envoyée au dispositif (22) de commande et au dispositif (24) de calcul et, de plus, des valeurs $(U_{V1}, ..., U_{Vn}; \Delta U_1, ... \Delta U_{n-1})$ de mesure de tension de la répartition de la tension de blocage détectée sur les semi-conducteurs (2) étant envoyée au dispositif (24) de calcul.

5. Dispositif (14) suivant la revendication 4, caractérisé en ce que le dispositif (14) comprend un dispositif (20) de surveillance de dissymétrie, auquel sont envoyées du côté de l'entrée des valeurs $(\Delta U_1, ...., \Delta U_{n-1})$ de mesure de tension de la répartition de la tension de blocage détectée sur les semi-conducteurs (2) et qui est relié du côté de la sortie, d'une part, au dispositif (22) de commande, et, d'autre part, au dispositif (26) de mise en mémoire intermédiaire.

6. Dispositif (14) suivant la revendication 4, caractérisé en ce qu'il est prévu comme dispositif (14) un microprocesseur.

7. Dispositif (14) suivant la revendication 4, caractérisé en ce que le dispositif (14) et le modulateur (18) d'impulsion forment une unité.

EP 0 750 808 B1

FIG 1

10

EP 0 750 808 B1

FIG 2

11

FIG 3

12

FIG 4

FIG 5